# EUROPEAN PATENT APPLICATION

(11) **EP 0 526 030 A1**
(43) Date of publication of application: **03.02.1993**
(21) Application number: 92306413.3
(22) Date of filing: 14.07.1992
(51) Int. Cl.: G06F 12/02, G11C 7/00

(54) **Read and write circuitry for a memory**

(30) Priority: 30.07.1991 GB 9116480
(71) Applicant: INMOS LIMITED, Bristol BS12 4SQ (GB)
(72) Inventor: Monk, Trevor Kenneth, Bexley, Kent DA5 3BX (GB)
(74) Representative: Palmer, Roger

(57) **Abstract**

A main memory is provided with at least one temporary store (21,22) for holding data and a memory address, the store having non-addressed inputs and a faster write operation than the main memory. Write circuitry has an input (32) to determine respective write cycles and is coupled to the temporary store to load data and an associated address into the temporary store during one write cycle and transfer circuitry (23,13) transfers data from the temporary store (21) to the memory (11) at an address indicated during a subsequent write cycle. Read circuitry has an input (20) for a read address and comparator circuitry (27) for comparing the read address with an address in the temporary store (22). Transfer circuitry (24) selects an output of data from either the temporary store (21) or the memory (11) depending on an output of the comparator circuitry (27).

## Description

The invention relates to memories having a plurality of addressable locations for holding data in which data is written to selected locations during respective write cycles and data is read from selected locations during respective read cycles. The invention is particularly concerned with the operation of such a memory which avoids loss of data which is to be written into the memory and presented late in a write cycle. The invention is particularly applicable to computer memories such as SRAMs, DRAMs and EPROMs.

Computer memories are well known in which data is written to one or more selected addressable memory locations during a write cycle. During a write cycle data must be presented to the write circuitry sufficient time before the end of the write cycle in order that the data can pass into the memory and be stored in a memory cell. If the data is presented to the write circuitry too late it may not be stored in the memory cell in time and the data can be lost. In known memory systems the write cycle of a memory having a large number of addressable memory locations may involve a plurality of operations. Typically such operations during the write cycle will include inputting an address which is to be written to and decoding that address. A write enable signal must be generated and the control logic for the memory must be set to permit a writing operation. There will also be a data input phase and finally turning off the write enable signal to terminate the write phase. The larger the memory the greater the time necessary to direct incoming data to the correct memory cells. Commonly, the larger the memory the longer are the data lines and bit lines extending through the memory array. The longer the lines the higher the capacitance of the data lines and bit lines and thereby the time taken to transmit the data into the correct cells in the memory array may be increased. In many memory devices the data must be passed through driver circuits in order to transmit the data to the memory cells and the larger the memory array the larger the load on the driver circuits and the slower the consequential operation unless the power used by the memory circuitry is increased. It is clearly undesirable to increase the power consumption and consequently the larger the memory array the more time may be required during each write cycle. In order to avoid incorrect operation of the memory system these time requirements to drive data to the correct memory cells may call for earlier presentation of the data during each write cycle to allow the maximum time to avoid the data being lost. On the other hand circuitry which is generating the data for writing to the memory may often require the maximum time to generate and present the data to the memory circuitry and it is therefore desirable to allow presentation of the data as late as possible in the write cycle. Consequently the requirements of the circuitry generating and presenting the data may be opposed to the requirements of the memory circuitry which require the data to be presented as early as possible in the write cycle.

It is an object of the present invention to provide an apparatus and method which permits the presentation of data late in a write cycle without loss of that data.

The invention provides a method of writing data to, and reading data from, a memory having a plurality of addressable storage locations which method comprises determining read cycles during each of which data may be read from a selected location in the memory and write cycles during each of which data may be written into a selected location in the memory, during one write cycle loading data and an associated memory location address for that data in a temporary store which has a faster write operation than said memory, during a subsequent write cycle transferring said data to the memory location indicated by said associated address, and during a read cycle inputting a read address, comparing said read address with the address in the temporary store and outputting data from either the temporary store or said memory, the temporary store being selected for the output if the read address is located in the temporary store.

Preferably the loading of said data and address to the temporary store is effected without decoding an address within the temporary store thereby allowing the temporary store to operate with a very short time cycle in receiving and storing the data.

Commonly the transfer of data to the memory location will include decoding the memory address and may include operation of driver circuits to transfer data to the memory location.

Preferably each read cycle includes determining a selected memory address from which data is to be read, comparing said selected address with an address in the temporary store and if no corresponding address is held in the temporary store addressing the memory at the selected address and reading data from said selected memory address.

The present invention also provides a memory having a plurality of addressable locations, read and write circuitry coupled to said memory and including at least one temporary store for holding data and an associated memory address, said temporary store having non-addressed inputs and a faster write operation than said memory, said write circuitry having an input to determine respective write cycles and being coupled to said temporary store to load data and an associated address into the temporary store during one write cycle, and transfer circuitry to transfer data from the temporary store to the memory at an address indicated by said associated memory address during a subsequent write cycle, said read circuitry having an input for a read address and comparator circuitry for comparing said read address with an address in the temporary store, the transfer circuitry including selection circuitry to select an output of data from either the temporary store or said memory dependant on an output of said comparator circuitry.

Preferably said read and write circuitry includes a comparator coupled to an input to compare a selected address which is input in a read cycle with an address held in said temporary store and coupled to said transfer circuitry to output data from the temporary store if the address in the temporary store corresponds to the selected address, and to output data from the selected memory address if the address in the temporary store does not correspond to said selected address.

The invention is particularly applicable to SRAMs, DRAMs and EPROMs. It is applicable to both synchronous and asynchronous memories.

An embodiment of the invention will now be described by way of example and with reference to the accompanying drawing which shows a block diagram of one embodiment of the invention.

In this example a main memory 11 is an asynchronous SRAM of conventional design having a plurality of addressable memory cells which can be addressed by use of row and column decoders and data written to selected memory locations by use of driver circuits. The main memory 11 has an input 12 for indicating the address of the selected memory location and a further input 13 for data which is to be written into the main memory. An output 14 is provided for data which is read from the memory.

The memory circuitry includes read and write circuitry to permit late presentation of data and an associated address during a write cycle. This read and write circuitry includes a first input 19 for data which is to be written into the memory and a second input 20 for an associated address for each data input to indicate the main memory address in which the data is to be stored. In addition a temporary store comprises a data memory 21 and an address memory 22. These may each be provided by one or more registers. The data input 19 is connected to the data memory 21 which has an output 23 connected to the main memory input 13 and to a data multiplexor 24 connected to the output 14 of the main memory. The data multiplexor has a final output 25 for outputting data which is read from the memories 21 or 11.

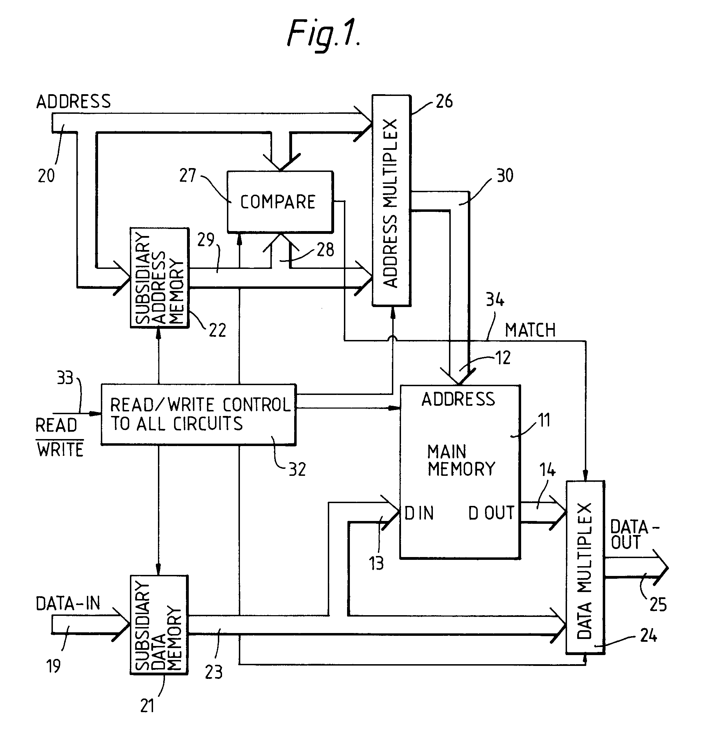

The address input 20 is connected to the temporary memory 22 and to an address multiplexor 26. The address input 20 is also connected to a comparator unit 27 arranged to receive as an input 28 an output 29 from the temporary address memory 22. The output 29 from the memory 22 is also connected to the address multiplexor 26. The address multiplexor 26 provides an output 30 which is connected to the address input 12 of the main memory 11. The read and write circuitry includes control logic 32 having an input 33 in the form of a read/write signal. This input 33 is in this example arranged to be driven high when a reading operation is required and low when a write operation is required. The control logic 32 is coupled to each of the memories 11, 21 and 22 as well as to the comparator unit 27 and address multiplexor 26 and data multiplexor 24. The control logic 32 provides control signals to control the time and mode of operation of each of the connected units shown in Figure 1.

The operation of this apparatus is as follows. At the end of each write cycle data which is input at input 19 is stored temporarily in the memory 21 which operates significantly faster than the main memory 11. The reason for this is that the memories 21 and 22 are both small and neither requires any decoding of addresses in order to permit data to be written into them. As they are small capacity memories they avoid the problems of long data lines and bit lines with high capacitance and the slow operating driver circuits for loading data into them. The main memory 11 on the other hand is typically a large conventional SRAM requiring the operation of decoding circuitry and driver circuits in order to write data into selected memory locations. At the same time as the data is written into the temporary memory 21 the associated address for that data is loaded into the fast temporary memory 22 and due to the fast operation of both these memories they effectively allow input of data to be accepted right at the end of a write cycle.

At the start of the next write cycle data which is stored in the subsidiary memory 21 is transferred to the main memory 11 at the address which was also stored in the subsidiary memory 22. This transfer is carried out under the control of the control circuits 32. In this way the address and data to be written to the main memory is presented to the main memory decoding and driving circuits at the beginning of the write cycle and consequently the full write cycle time is available in order to transmit the data to the correct memory cells. The temporary memory 21 can then be used to receive new data in a write cycle.

Read cycles must ascertain whether the required data resides in temporary memory 21 or has already been transferred into main memory 11, and output data must be obtained appropriately. These operations are performed in the following way. At the start of each read cycle the incoming address which is provided on bus 20 is compared by the comparator 27 with the address output on bus 29 from the temporary memory 22. If there is no match then the required output data must come from the main memory 11. The address multiplexor 26 in such a case supplies the address from input 20 to the input 12 of the main memory 11 and the data multiplexor 24 selects data read out from output 14 of the main memory 11 so that the data output at 26 is read from the main memory at the address indicated by the input 20. The function of the data multiplexor 24 is controlled by a signal on line 34 from the comparator 27.

If on the other hand the comparator 27 finds at the beginning of a read cycle that the address stored in the address memory 22 corresponds with that input at 20, then a signal is supplied on line 34 to the data multiplexor 24 to output the data from the output 23 of the temporary data memory 21. This is passed through the multiplexor 24 and provides the data output at 25.

It will be understood that although the above example is related to an asynchronous SRAM the invention is also applicable to synchronous SRAMs to DRAMs and also to EPROMs. Some of the additional circuits described in Figure 1 may also be incorporated in the main memory circuitry. For example, memories which incorporate redundancy may already include a data multiplex circuit which may carry out the dual function of permitting operation of the redundant memory section as well as providing the function of the data multiplexor 24 described above.

When applying the invention to EPROMs, write operations are generally very slow with EPROMs and so the system speed may be increased if fewer write operations are needed. The temporary stores 21 and 22 referred to above may be provided by a number of sets of registers which can be arranged to form a scratch pad store. This store can be filled with changes before they are transferred to the main EPROM array by a write operation. Thereby the number of separate write operations may be reduced and the EPROM reliability improved.

It will be appreciated that in all the above examples the use of the fast operating temporary stores for both data and associated address enable the data and associated address to be presented very late in a write cycle without loss. This does thereby allow increased time for the generation and presentation of data for writing operations even when short write cycles are used.

The invention is not limited to the details of the foregoing example.

## Claims

1. A method of writing data to, and reading data from, a memory having a plurality of addressable storage locations which method comprises determining read cycles during each of which data may be read from a selected location in the memory and write cycles during each of which data may be written into a selected location in the memory, during one write cycle loading data and an associated memory location address for that data in a temporary store which has a faster write operation than said memory, during a subsequent write cycle transferring said data to the memory location indicated by said associated address, and during a read cycle inputting a read address, comparing said read address with the address in the temporary store and outputting data from either the temporary store or said memory, the temporary store being selected for the output if the read address is located in the temporary store.

2. A method according to claim 1 in which the loading of said data and address to the temporary store is effected without decoding an address within the temporary store.

3. A method according to claim 2 in which the said data and address are held in one or more latches or registers as said temporary store.

4. A method according to any one of the preceding claims in which the transfer from the temporary store to the memory is effected in the next write cycle after loading into the temporary store.

5. A method according to any one of the preceding claims in which each read cycle includes determining a selected memory address from which data is to be read, comparing said selected address with an address in the temporary store and if no corresponding address is held in the temporary store addressing the memory at the selected address and reading data from said selected memory address.

6. A memory having a plurality of addressable locations, read and write circuitry coupled to said memory and including at least one temporary store for holding data and an associated memory address, said temporary store having non-addressed inputs and a faster write operation than said memory, said write circuitry having an input to determine respective write cycles and being coupled to said temporary store to load data and an associated address into the temporary store during one write cycle, and transfer circuitry to transfer data from the temporary store to the memory at an address indicated by said associated memory address during a subsequent write cycle, said read circuitry having an input for a read address and comparator circuitry for comparing said read address with an address in the temporary store, the transfer circuitry including selection circuitry to select an output of data from either the temporary store or said memory dependant on an output of said comparator circuitry.

7. A memory according to claim 6 in which said temporary store comprises one or more latches or registers.

8. A memory according to claim 6 or 7 in which said read and write circuitry have a common input connected to the comparator to compare a selected address which is input in a read cycle with an address held in said temporary store, the comparator being coupled to said transfer circuitry to output data from the temporary store if the address in the temporary store corresponds to the selected address, and to output data from the selected memory address if the address in the temporary store does not correspond to said selected address.

9. A method according to any one of claims 1 to 5 in which the memory is an SRAM.

10. A memory as claimed in any one of claims 6 to 8 in which the addressable memory comprises an SRAM.
